# EUROPEAN PATENT APPLICATION

(11) **EP 1 462 913 A2**
(43) Date of publication of application: **29.09.2004**
(21) Application number: 04251824.1
(22) Date of filing: 26.03.2004
(51) Int. Cl.: G06F 1/16, H05K 7/14

(54) **Universal computer enclosure**

(30) Priority: 28.03.2003 US 403794; 30.01.2004 US 769096; 30.01.2004 US 769136
(71) Applicant: SharkRack, Inc., Union City, California 94587 (US)
(72) Inventor: Davis, Brooks I, San Jose California 95148 (US); Freitas, Michael J., Livermore California 94550 (US)
(74) Representative: Collins, John David

(57) **Abstract**

An adjustable computer device cabinet stores computer devices, equipment and accessories from various device vendors. This allows one cabinet to be used for multiple brands of computer devices, rather than requiring a separate type of cabinet for each brand of computer device. The cabinet includes mounting holes and adaptors that will work with many different computer devices and accessories. Devices support structures with narrowing adaptors are positioned freely at desired depths within the cabinet. Additionally, tool-less apparatus allow computer devices and accessories of various vendors and sizes to be attached, removed, and adjusted within the cabined without tools. Moreover, the cabinet is adapted to store accessories in zero unit space that allows maximum use of rack unit space for computer devices.

## Description

### BACKGROUND OF THE INVENTION

### FILED OF THE INVENTION

This invention is related generally to a computer enclosure, and more particularly, to an adjustable computer enclosure that easily mounts computer devices, equipment and accessories of different sizes from different vendors.

### DESCRIPTION OF RELATED ART

Modem businesses make increasing use of multiple computer devices and equipment, such as servers. This computer equipment is typically placed in specialized cabinets for use and storage. The Electronic Industries Association has produced a standard, EIA-310-D, for these specialized cabinets. The cabinets have rails on the left and right sides near the front of the cabinet with holes that are used to attach the computer equipment. The EIA-310-D standard defines the distance between the left and right rails, as well as the spacing of the holes in the rails. Many large computer device and server manufacturers conform to this standard.

However, the EIA-310-D standard leaves many aspects of the cabinet unspecified. For example, the holes in the rails may be square or circular. Also, while the distance between the left and right side rails is specified, creating a specified width of an opening between the rails, the standard does not specify a width available within the cabinet behind the rails or a depth of the cabinet. In addition, the standard does not address where or how to attach accessories, such as a power strip. Thus, many computer component and server vendors sell products that conform to the EIA-310-D specification, but have different mounting and spacing requirements. Consequentially, specialized cabinets are currently designed to hold the equipment from a single vendor. Devices that perform other tasks would be purchased from another vendor and stored in another cabinet designed for that second vendor.

A problem stemming from the multiple types of cabinets are the multiple types of tools required for attachment and removal of the computer devices and equipment within the cabinets. It can be costly and time-consuming to have such appropriately designed tools available for all types of computer devices and equipment in all cabinets in which they are stored. As new equipment is added or current equipment is reorganized, new tools may have to be purchased to accommodate the adjusted space requirements. Thus, these attachment mechanisms do not provide a universal solution for difficult attachment and removal of computer equipment from various vendors.

In addition, there might be only minimal extra space for maneuvering with tools. It is often necessary to move around equipment in the cabinet for repair, replacement, or reorganization. But it can be difficult to manipulate the tools in order to firmly and easily attach, remove, or even adjust the computer components, and to place components in the most space-effective positions. To manage these problems, unused space is incorporated into the cabinet so that equipment is easily reachable with tools for adjustment. Thus, there is wasted space in the cabinet where computer devices and equipment simply cannot be mounted.

Another problem related to space efficiency is that attached accessories often use valuable space, or rack units (RUs), within the computer cabinet, taking away from available rack unit space for computer devices. A rack unit is equivalent to 1.75", or three mounting holes. Computer cabinets are measured in available rack unit space along its vertical members, and computer equipment is measured in the amount of rack unit space needed within the computer cabinet for storage. But in typical set-ups, accessories consume rack space needed for the equipment. Furthermore, it is difficult to maneuver tools inside the computer cabinet for attaching the accessories when the computer cabinet is tightly packed.

Accordingly, it is desirable to provide a flexible computer equipment cabinet that allows easy mounting of various computer equipment and devices, and accessories from various vendors for storage without depriving storage space needed for computer equipment.

### SUMMARY OF THE INVENTION

One embodiment of the invention provides a computer device cabinet that has one or more features that give the cabinet flexibility for storing computer devices from multiple different vendors and having different cabinet requirements. This allows storage of different computer devices from different vendors with different cabinet requirements in a single cabinet. Alternatively, multiple units of the same flexible cabinet may be purchased and each used with a different type of computer device from a vendor. In either case, purchasing cabinets for storage of computer devices is made simpler for customers.

One feature that adds flexibility to the cabinet is mounting holes that will work with many different computer devices with different requirements for sizes and/or shapes of the mounting hole. Adapters are used with the mounting holes to allow the different computer devices to be mounted to the same set of mounting holes. Another feature is a set of device support structures that may be positioned freely at desired depths within the cabinet. This allows optimal positioning of the computer devices within the cabinet to ensure door clearance and proper cooling space. Additionally, it allows computer devices of varying depths to be mounted in the cabinet, optionally with the use of adapters. Yet another feature is an interior width that is wide enough to fit a large variety of computer devices. Adapters are used to narrow the width and allow mounting and storage of computer devices that require a narrower width.

In another embodiment, a tool-less apparatus is adapted for attachment to the cabinet or other enclosures. A bracket apparatus has features that allow for its easy attachment to and removal from support structures and frame tracks in the cabinet. In addition, the bracket apparatus has features that allow computer devices from multiple different vendors to be easily and securely attached to the bracket apparatus. Thus, the bracket apparatus can be placed in a desired, space-efficient location in a storage cabinet, such that components can be attached to the bracket apparatus in these space-efficient locations. The devices can also be easily released from the apparatus for removal from or adjustment within the cabinet.

In one embodiment, the bracket apparatus comprises at least one fastener coupled to a frame, and the fastener is adapted for connecting to an enclosure. In a further embodiment, the bracket apparatus comprises a pivotable bar that pivots to secure the computer component to the bracket apparatus.

In another embodiment, the cabinet is adapted to store accessories in zero unit space. The cabinet comprises a frame with vertical members coupled with horizontal members and/or frame tracks. While the frame supports computer devices in rack unit space, the frame tracks are adapted to attach accessories, such as a power source, a cooling device, or a wire guide, in zero rack unit space. Rack unit space is a dimension of the enclosure that describes how much space is available for the computer devices. Zero rack unit space, by contrast, is storage space contained within the enclosure that does not consume rack unit space. One embodiment of the frame tracks comprise the horizontal members of the frame.

One embodiment of zero rack unit space comprises a width approximately equal to, for example, a width of a vertical member, a width of cooling space, etc. Another embodiment of zero rack unit space comprises a depth approximately equal to, for example, a length of a horizontal member, or a depth of the cabinet. In another embodiment, the dimensions of the frame and the frame tracks are specified by the EIA-310-D standard. For example, spacing between holes on the frame tracks and the frame, the width between vertical members of the frame, and other dimensions can conform to the standard.

### BRIEF DESCRIPTION OF THE DRAWINGS

FIG 1 is a perspective view that illustrates the front, top, and right side of a computer device cabinet according to one embodiment of the present invention.

FIG 2 is a perspective view that illustrates the rear, top, and right side of the computer device cabinet according to one embodiment of the present invention.

FIG 3a is a front view that illustrates the left and right front device support structures to which computer devices are attached according to one embodiment of the present invention.

FIG 3b is a rear view that illustrates the left and right rear device support structures to which computer devices are attached according to one embodiment of the present invention.

FIG 3c is a close up perspective view that illustrates a computer device mounted within the cabinet according to one embodiment of the present invention.

FIGs 4a-4c are perspective views that illustrate adapters used with holes to attach different computer devices to the cabinet according to one embodiment of the present invention.

FIG 5 is a perspective view that illustrates the right front rail, holes within the right front rail, and the use of an adapter from FIG 4a with the rail according to one embodiment of the present invention.

FIG 6 is a top view that illustrates the left and right front device support structures as well as the left and right rear device support structures according to one embodiment of the present invention.

FIG 7 is a perspective view that illustrates a narrowing adapter bracket according to one embodiment of the present invention.

FIG 8 is a side view that illustrates the left front device support structure according to one embodiment of the present invention.

FIG 9 is a perspective view that illustrates how a narrowing adapter bracket is attached to a device support structure according to one embodiment of the present invention.

FIG 10 is a top view that illustrates four device support structures with the narrowing adapter brackets installed according to one embodiment of the present invention.

FIGs 11a-b are perspective views that illustrate how the device support structures are positioned within the cabinet along the tracks according to one embodiment of the present invention.

FIG 12 is a perspective view that illustrates the front, top, and left side of an assembled bracket according to one embodiment of the present invention.

FIG 13 is a perspective view that illustrates the rear, top, and left side of an assembled bracket according to one embodiment of the present invention.

FIG 14 is a perspective view that illustrates the front, top, and left side of a part of a disassembled bracket according to one embodiment of the present invention.

FIG 15 is a perspective view that illustrates the front, top, and left side of a part of a disassembled bracket according to one embodiment of the present invention.

FIG 16 is a side view that illustrates the assembly of the two parts of a bracket according to one embodiment of the present invention.

FIG 17 is a side view that illustrates a computer component mounted on a bracket according to one embodiment of the present invention.

FIG 18 is a perspective view that illustrates the mounting of a computer component on two brackets according to one embodiment of the present invention.

FIG 19 is a side view that illustrates a mounted computer component according to one embodiment of the present invention.

FIGs 20a-c are perspective views of a computer device cabinet that illustrate computer components mounted within the enclosure according to one embodiment of the present invention.

FIG 21 is a perspective view of a computer device cabinet that illustrates both servers and computer components mounted within the enclosure according to one embodiment of the present invention.

FIG 22 is a side view that illustrates a computer component mounted to two brackets according to one embodiment of the present invention.

FIG 23 is a perspective view that illustrates the front, top, and left side of a bracket in an open position according to one embodiment of the present invention.

FIG 24 is a perspective view that illustrates the front, top, and left side of a bracket in a closed position according to one embodiment of the present invention.

FIG. 25 is a bottom view that illustrates dimensions of zero rack unit space according to one embodiment of the present invention.

### DETAILED DESCRIPTION OF THE PREFERRED EMBODIMENTS

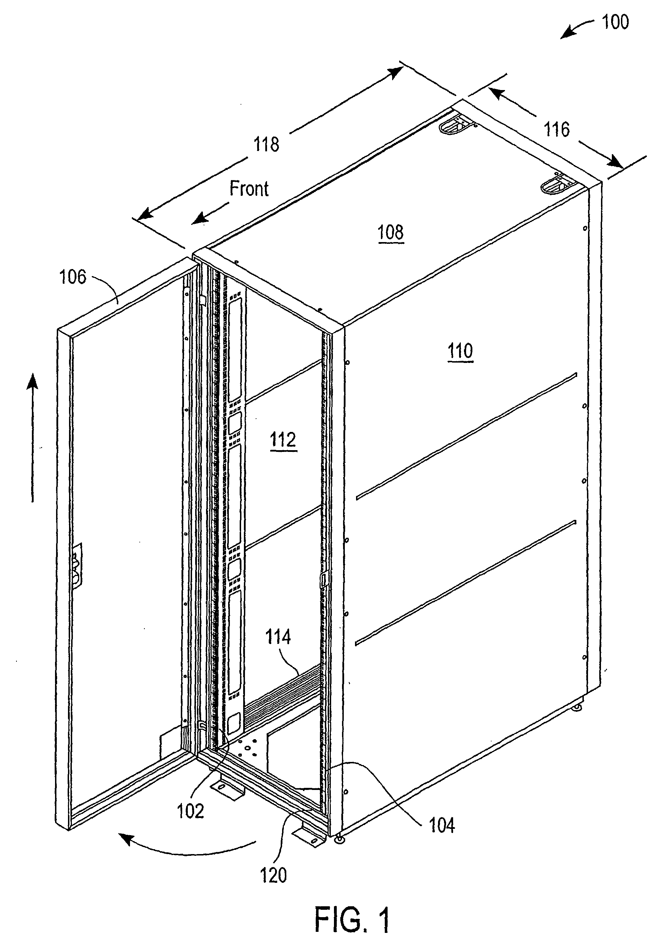

FIG 1 is a perspective view of the front, top, and right side of a computer device cabinet 100 that provides added flexibility for allowing the mounting of computer devices from several different vendors with different mounting requirements. This additional flexibility provides the advantage of allowing use of just one cabinet 100 to contain equipment from several different computer device vendors, rather than purchasing several cabinets.

Alternatively, the additional flexibility may provide the advantage of allowing the cabinet 100 to conform to any one set of mounting requirements for computer devices. This type of flexibility provides the advantage of purchasing just one type of cabinet 100 for different mounting requirements, rather than purchasing multiple different types of vendor specific cabinets 100.

In one embodiment, the computer cabinet 100 conforms to the EIA-310-D standard, and also conforms to requirements set by various computer equipment vendors. In one embodiment, the vendors include International Business Machines Corporation of Armonk, New York, Dell Computer Corporation of Austin, Texas, Sun Microsystems, Inc. of Santa Clara, California, Compaq and Hewlett-Packard, both owned by Hewlett-Packard, Inc. of Palo Alto, California, and Cisco Systems, Inc. of San Jose, California. In other embodiments, the cabinet 100 may conform to another standard, or not conform to any particular standard, but simply include features providing extra flexibility so that many different computer devices from different vendors may be stored in the cabinet 100.

In the description below, a cabinet 100 is described that includes multiple different features. Each feature increases cabinet 100 flexibility. While it may be desirable to include all of the features that increase flexibility in a cabinet 100, the cabinet 100 may also include just one of the features, or just a few of the features, depending on which flexibility improvements are desired. Mounting holes allow direct mounting of some computer devices and/or that accept adapters for mounting other computer devices. An effective interior width of the cabinet 100 is large enough for mounting the widest computer device desired to be mounted in the cabinet 100. Adapters may be used for narrowing the effective width of the cabinet 100 for computer devices that require a narrower width or that require a varying width. Structures to which the computer devices are mounted and which support the computer devices that may be variably positioned within the cabinet 100. This allows computer devices to be positioned forward or back within the cabinet 100 as desired. The distance between front and rear support structures may be chosen using variable positioning. A single distance may be chosen that is appropriate for use with several types of computer devices. Alternatively, the support structures may be placed far enough apart for computer devices with large depth, and adapters used to decrease the depth for attaching computer devices that require smaller depths. An overall cabinet 100 depth the meets the minimum requirements of several different types of computer devices. Cooling features are sufficient for many types of computer devices. The cooling can include free space within the cabinet 100 and vents in the cabinet 100 enclosure. Space efficiency features allow tool-less attachment and removal of computer devices, equipment and accessories within the cabinet 100. Also, zero unit space features allow accessories to be attached in zero unit space that preserves rack unit space for computer devices and equipment.

As seen in FIG 1, the cabinet 100 includes a left front device support structure 102 and a right front device support structure 104. The computer devices are mounted in the cabinet 100 by attaching the devices to the left and right front device support structures 102, 104, as well as to left and right rear device support structures (not shown in FIG 1). The left and right front device support structures 102, 104 are connected to tracks 114 within the cabinet 100 in one embodiment. There are upper and lower left side tracks 114 and upper and lower right side tracks 114 (only the lower left side track 114 is shown in FIG 1). The tracks 114 are connected to a cabinet frame 120. The cabmet 100 also includes a door 106, a top panel 108, a right panel 110, and a left panel 112, each of which are connected to the cabinet frame 120. A rear door (not shown in FIG 1) may also be included. In other embodiments, the device support structures 102, 104 may be connected directly to the frame 120, the side panels 110, 112, or to other parts of the cabinet 100, rather than to the tracks 114. Note that while the term "cabinet" is used, the present invention may lack one or more of the enclosing panels. The cabinet 100 may have one or more sides open to the environment, rather than be enclosed on all sides.

In one embodiment, the cabinet 100 has exterior dimensions of a width 116 of approximately 24 inches and a depth 118 of approximately 46.6 inches.
Typically, the cabinets 100 are placed in data centers, which have square floor tiles 24 inches on a side. In such a data center, the cabinet 100 fits on two floor tiles, which eases acquisition of data center space and allows for easy connection of wires from below the data center floor to the cabinets 100. Since the cabinet 100 can be placed on a space one square wide, adjacent squares may be lifted to access wiring beneath the floor square. This embodiment has an interior depth within the cabinet 100 and available for use by computer devices of approximately 44 inches, which allows mounting and storage of many brands of computer devices within the cabinet 100, including IBM, Dell, Sun, Hewlett Packard, Compaq, and Cisco.

In one alternative embodiment, the cabinet has an interior depth within the cabinet 100 of approximately 34 inches. The exterior depth 118 of this embodiment is approximately 36 inches, which allows this cabinet 100 to fit in a space in a data center that is one and a half floor tiles deep. Other exterior depths 118 and widths 116 and interior depths and widths may also be chosen, depending on what size computer devices are to be stored within the cabinet. One way to determine the interior depth and width desired is to determine the largest interior depth required by the computer devices to be stored in the cabinet 100 and ensure that the interior depth is at least that large. In one embodiment, the interior depth of the cabinet 100 is at least 36 inches, which is deep enough for the computer device (28 inches) and cooling requirement (at least 8 inches of free space behind the computer device and in front of the rear door) of an IBM computer device.

The cabinet 100 also has cooling features sufficient to meet the most stringent cooling requirements of the computer devices to be mounted in the cabinet 100. For example, in one embodiment, the front door 106 has greater than 19 square inches of open cooling vent area per rack unit in the front device support structures 102, 104. The rear door has more than 25 square inches of open cooling vent area per rack unit in the front device support structures 102, 104. This is enough venting area for the computer devices to be mounted in the cabinet 100. In other embodiments, the cooling area of the cabinet 100 may be greater if required by the computer devices that are to be mounted in that cabinet.

Many computer devices also specify requirements for the amount of load a cabinet 100 can bear per rack unit in the front device support structures 102, 104. The cabinet 100 is designed so that it may bear the amount of load specified by the computer device with the largest load bearing requirement. In one embodiment, the cabinet 100 designed to bear more than 35 pounds per rack unit in the front device support structures 102, 104. In this embodiment, there are 42 rack units in the front device support structures 102, 104, so the cabinet 100 is capable of bearing at least 1470 pounds. Note that, although measurements discussed herein are in English units such as inches and pounds, the cabinet 100 is adjustable to conform to other international measurement standards, such as those used in Europe and Asia.

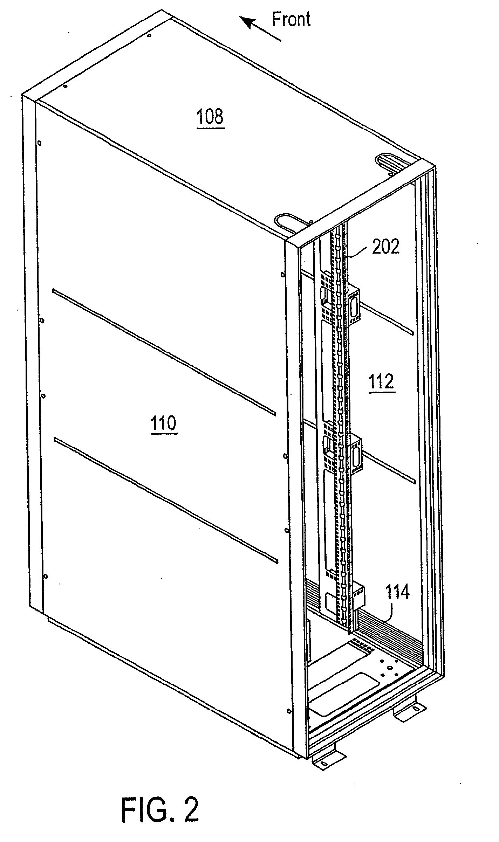

FIG 2 is a perspective view of the rear, top, and right side of the computer cabinet 100. The cabinet 100 includes a left rear device support structure 202 and a right rear device support structure 204 (not shown in FIG 2). When the computer devices are mounted in the cabinet 100, the devices are typically attached to the rear device support structures 202, 204 in addition to the front device support structures 102, 104. The left and right rear device support structures 202, 204 are also connected to tracks 114 on the upper and lower left and right sides within the cabinet 100.

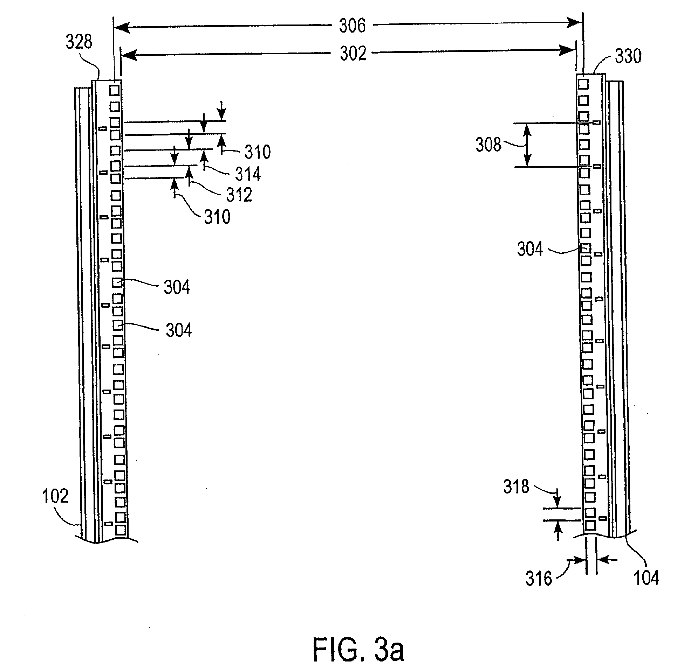

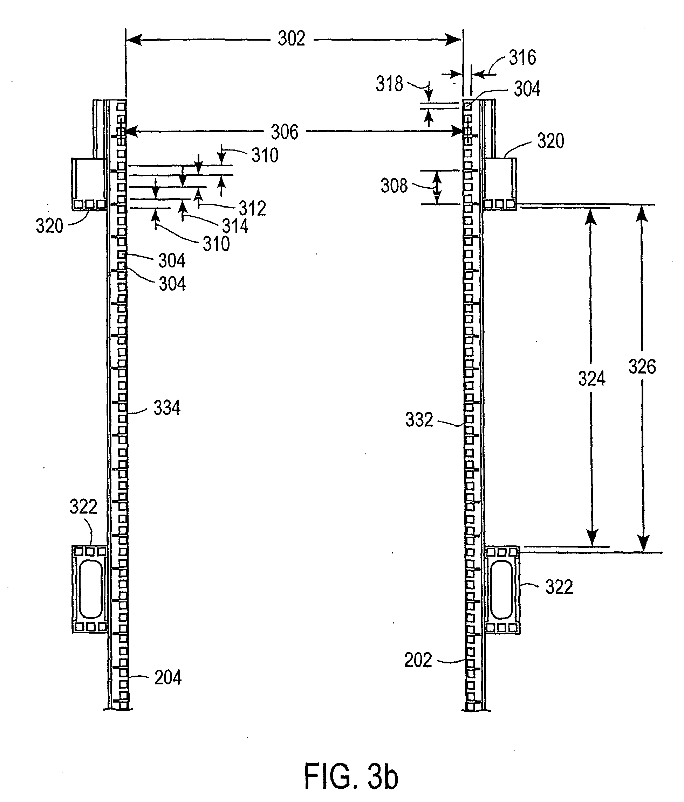

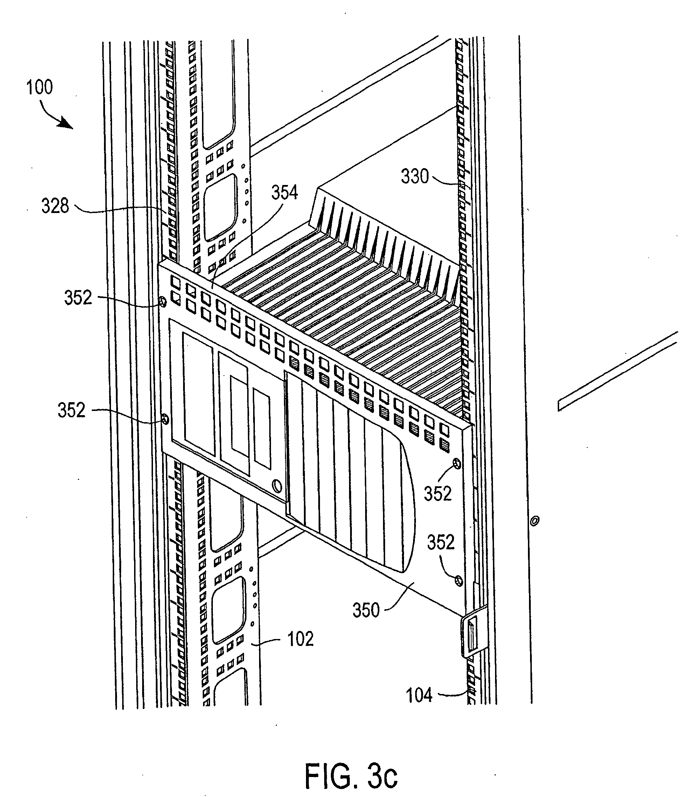

FIG 3 a is a front view that illustrates the left and right front device support structures 102 and 104 to which computer devices are attached according to one embodiment of the present invention. The left and right device support structures 102 and 104 each include a rail 328, 330 with a surface parallel to the front of the cabinet 100 and perpendicular to the right and left panels 110, 112. Each of the left and right front device support structures 102, 104 has mounting holes 304 spaced along the rail 328, 330. Typically, the computer equipment is mounted to the device support structures 102 and 104 by attaching to the holes 304 in the rails 328, 330. The holes 304 are spaced according to the EIA-310-D standard in one embodiment of the present invention.

Under the EIA-310-D standard, there are multiple rack units 308 along each device support structure 102, 104. Each rack unit 308 has three mounting holes 304. The distances 312, 314 center-to-center of the holes 304 within a rack unit 308 are approximately 0.625 inches. The distance 310 center-to-center between the last hole 304 of one rack unit 308 and the first hole 304 of another rack unit 308 is approximately 0.50 inches. This means that each rack unit 308 extends approximately 1.75 inches along the rails 328, 330. In other embodiments, the holes 304 can be sized and spaced appropriately according to a different standard, or simply sized and spaced to allow attachment of various non-standard computer devices.

While the EIA-310-D standard specifies the spacing of the holes 304, it does not specify the size or shape of the holes. In one embodiment of the present invention, the holes 304 are substantially square. The holes 304 have a width 316 of approximately 0.38 inches, and a height 318 of approximately 0.38 inches. This size is large enough to accept the mounting hardware of computer devices from many different vendors, and to accept adapters that make the holes compatible with computer devices that require different sized or shaped holes 304.

So that devices conforming to the EIA-310-D standard will fit correctly when attaching them to the left and right front device support structures 102 and 104, the distance 302 between the inside edges of the left and right front rails 328, 330 is approximately 17.81 inches, and the center-to-center distance 306 between holes 304 in the left rail 102 and holes 304 in the right rail 104 is approximately 18.31 inches, which is consistent with the EIA-310-D standard and the requirements of multiple computer device manufacturers. In other embodiments, the distances between the rails 328, 330 and holes 304 can be different to comply with a different standard or with various non-standard computer devices.

FIG 3b is a rear view that illustrates the left and right rear device support structures 202 and 204 to which computer devices are attached. (Note that since this is a rear view, the left rear device support structure 202 appears on the right of FIG 3b, and the right rear device structure 204 appears on the left of FIG 3b.) The left and right rear device support structures 202, 204 are configured similarly to the front device support structures 102, 104. Each of the left and right rear device support structures 202, 204 has a rail 332, 334. The distance 302 between the rear rails 332, 334 and the center-to-center distance 306 between holes 304 in the right rail 334 and the holes 304 in the left rail 332 are substantially the same as the distances 302, 306 described above with respect to the left and right front device support structures. The rear rails 332, 334 have holes 304, which have placements, spacings, and sizes substantially the same as for the holes 304 in the front rails 328, 330.

In some embodiments of the present invention, additional top and bottom side brackets 320, 322 are also attached to the left and right rear device support structures 202, 204. In the illustrated embodiment, the side brackets 320, 322 include three holes 304 spaced as in a rack unit 308. Additionally, the distance 324 between the top and bottom side brackets 320, 322 is substantially the same as the distance 302 between the left and right rails 328, 330, and the center-to-center distance 326 between a hole 304 in a top side bracket 320 and a hole 304 in a bottom side bracket 322 is substantially the same as the center-to-center distance 306 between holes 304 in the left rail 328 and holes 304 in the right rail 104. This allows mounting of a computer device that takes up one rack unit 308 on each side of the cabinet 100, in addition to installing computer devices between the rails 102, 104 in the cabinet 100. In alternative embodiments, such additional top and bottom side brackets 320, 322 are also attached to the left and right front device support structures 102, 104.

FIG 3c is a close up perspective view that illustrates a computer device 350 mounted within the cabinet 100. In the illustrated embodiment, the computer device 350 is mounted to the front device support structures 102, 104 in the cabinet 100 by four attachment devices 352 that attach the computer device 350 to four holes 304 in the front rails 328, 330 through a faceplate 354. The attachment devices 352 may be straight edged hooks that hook over the edge of the square holes 304, screws that are screwed into round threaded adapters in the holes 304, or other attachment devices 352. Typically, the computer device 350 will be similarly attached to the rear rails 332, 334 and/or rear device support structures 202, 204. Alternatively, the holes 304 could simply be used as positioning reference devices with pins on the computer device 350 for positioning the computer device 350 correctly in the cabinet 100 without attaching the computer device 350 to the cabinet 100.

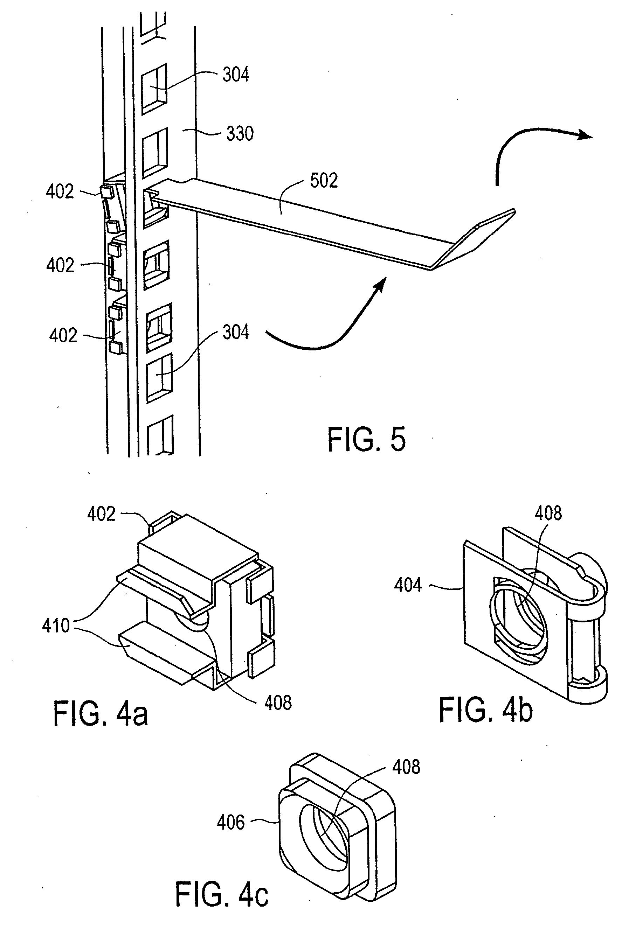

FIGs 4a-4c are perspective views of adapters 402, 404, 406 that are used with the holes 304 when a computer device 350 from a vendor is to be attached to rails 328, 330, 332, 334 with holes of a different shape or size than the actual holes 304 in the rails 328, 330, 332, 334. This allows mounting of computer devices 350 with different mounting requirements on the same rails 328, 330, 332, 334 within the cabinet 100 and increases the flexibility of what computer devices 350 may be used with the cabinet 100. The adapters 402, 404, 406 may also be used with holes 304 in the device support structures 102, 104, 202, 204, to attach the computer device 350 to the device support structures 102, 104, 202, 204 in addition to the rails 328, 330, 332, 334, or in place of attaching the computer device 350 to the rails 328, 330, 332, 334.

The adapters 402, 404, 406 are inserted in the hole 304 in the rail 328, 330, 332, 334 to effectively change the size and/or shape of the hole 304. Each of the adapters 402, 404, 406 shown in FIGs 4a-4c changes the effective shape of the hole 304 to a round hole because the adapter 402, 404, 406 itself includes a round hole 408. This round hole 408 may be of various sizes, and may be threaded or non-threaded, depending on the requirements of the computer device 350 to be attached using the adapter 402, 404, 406. Additionally, other adapters can change the shape of the hole 304 to a smaller square hole, to a rectangular hole, or to a hole of a different shape. An adapter may even completely block the hole 304 and replace the hole with a mounting hook or other device.

FIG 5 is a perspective view illustrating the right front rail 330, holes 304 within the right front rail 330, and the use of adapter 402 from FIG 4a with the rail 330. In the illustrated embodiment, a tool 502 is used to compress flanges 410 of adapter 402 illustrated from FIG 4a so that the adapter 402 may be inserted into the hole 304 and be firmly connected with the rail 330. The other two adapters 402 in FIG 5 have already been installed in the holes 304 of the rail 330 and are ready for use to attach a computer device 350 to the rail 330.

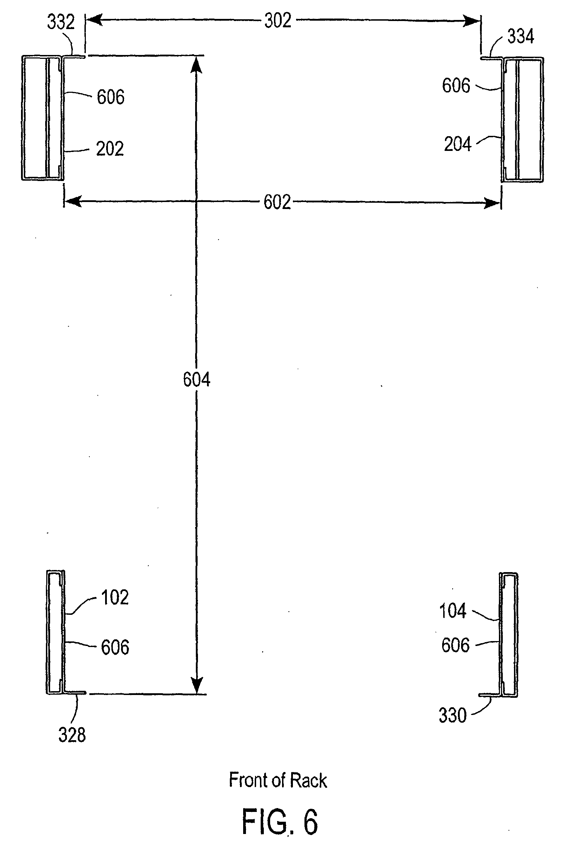

FIG 6 is a top view that illustrates the left and right front device support structures 102, 104 as well as the left and right rear device support structures 202, 204 according to one embodiment of the present invention. As described above with respect to FIG 3a, the inside edges of the front left and right rails 328, 330 are separated by a distance 302 of approximately 17.81 inches. Similarly, the rear left and right rails 332, 334 are also separated by the distance 302 of approximately 17.81 inches.

The device support structures 102, 104, 202, 204 are mounted to the rails 114 within the cabinet 100 so that the front rails 328, 330 have a depth distance 604 of approximately 29.13 inches from the rear rails 332, 334 in one embodiment. As will be described more fully below, the rails 114 allow the depth distance 604 between the front rails 328, 330 and the rear rails 332, 334 to be varied by a user. However, in the illustrated embodiment, the depth distance 604 of 29.13 inches is chosen because it is compatible with the requirements of the EIA-310-D standard as well as the requirements of a wide range of computer devices 350 from several different vendors. In one embodiment, this distance 604 of 29.13 inches is chosen because it is the distance 604 specified for use with one of the multiple computer devices 350 with which the cabinet 100 is to be used and falls within an allowable range of distances 604 specified by the rest of the multiple computer devices 350 with which the cabinet 100 is to be used.

Between the rails 328, 330, 332, 334, the width 602 between interior surfaces 606 of the left and right rear device support structures 202, 204 is approximately 19.76 inches. Similarly, between the rails 328, 330, 332, 334, the width 602 between interior surfaces 606 of the left and right front device support structures 102, 104 is also approximately 19.76 inches. These interior surfaces 606 are a surface of the device support structures 102, 104, 202, 204 that are parallel to the left and right side panels 110, 112, and toward the inside of the cabinet 100 interior, away from the side panels 110, 112. This width 602 is chosen to be great enough so that computer devices 350 from many different vendors will fit between the device support structures 102, 104, 202, 204. In the illustrated embodiment, the width 602 is chosen as approximately 19.76 inches to be compatible with the EIA-310-D standard, as well as with the widest requirements of computer devices 350 from Dell, Sun, Hewlett Packard, Compaq, and Cisco. In different embodiments, different widths are used.

The width 602 of FIG 6 is chosen so that the width 602 will be large enough for computer devices 350 from many different vendors. However, some computer devices 350 may require a width of less than the width 602. In such a case, a narrowing adapter bracket may be used.

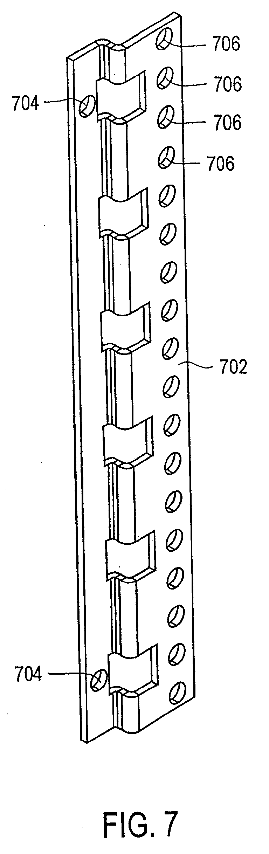

FIG 7 is a perspective view of such a narrowing adapter bracket 702. A narrowing adapter bracket 702 increases the flexibility of the cabinet 100 and allows the use of the cabinet 100 with a wider range of computer devices 350 with different width requirements. Some computer devices 350 may be attached to the narrowing adapter bracket 702 or to a non-rail portion of the device support structures 102, 104, 202, 204 in addition to attaching the computer devices 350 to the rails 328, 330, 332, 334, or in place of attaching the computer devices 350 to the rails 328, 330, 332, 334. The narrowing adapter bracket 702 has attachment holes 704 for attaching the narrowing adapter bracket 702 to the device support structures 102, 104, 202, 204. The narrowing adapter bracket 702 also includes device holes 706 for use in attaching the computer device 350 to the adapter bracket 702. In the illustrated embodiment, these device holes 706 are round and are spaced as in a rack unit with the same distances between holes 706 as described above with respect to the holes 304 of the rails 328, 330, 332, 334. In another embodiment, holes 706 of different shapes, and with different positioning schemes may also be used. Alternatively, the narrowing adapter bracket 702 may not require holes 704, 706 at all, but may use other structures to attach the bracket 702 to the device support structures 102, 104, 202, 204 and/or attach the computer device 350 to the narrowing adapter bracket 702.

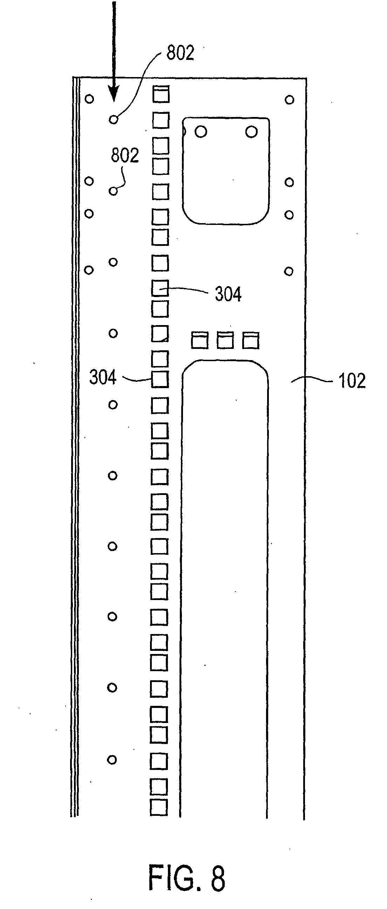

FIG 8 is a side view that illustrates the left front device support structure 102 in more detail. Note that while FIG 8 and the accompanying description illustrates the left front device support structure 102, the other device support structures 104, 202, 204 are typically configured in the same way as the left front device support structure 102. Thus, the description and illustration of the left front device support structure 102 is typically equally applicable to the right front device support structure 104, and the right and left rear device support structures 202, 204.

The left front device support structure 102 has adapter attachment holes 802 positioned to line up with the attachment holes 704 of the narrowing adapter bracket 702 to allow attaching the narrowing adapter bracket 702 to the left front device support structure 102. Various types of narrowing adapter brackets 702 may be attached at various vertical positions along the device support structure 102 to allow the attachment of computer devices 350 of varying widths within the same cabinet 100.

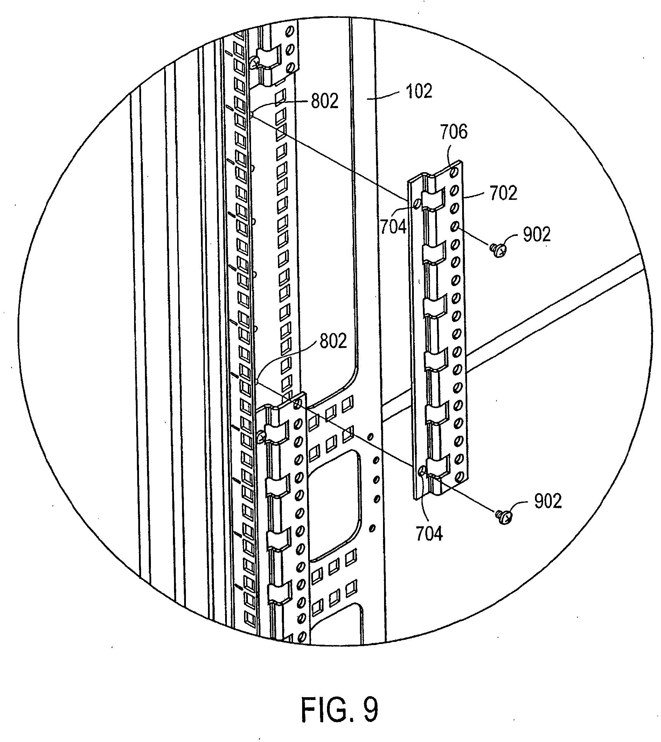

FIG 9 is a perspective view that illustrates how a narrowing adapter bracket 702 is attached to a device support structure 102 according to one embodiment of the present invention. Screws 902 go through the attachment holes 704 of the narrowing adapter bracket 702 and are fastened to the adapter attachment holes 802 of the device support structure 102. By attaching the narrowing adapter bracket 702 in such a way, the effective width 602 between front left and right device support structures 102, 104 or between the rear left and right device support structures 202, 204 is narrowed, allowing attachment of computer devices 350 that require narrower widths 602.

Returning to FIG 6, in other embodiments, the distance 604 between the left front and left rear rails 328 and 332 or right front and right rear rails 330, 334 may be chosen so that the distance 604 is at least as large as the greatest distance required by the computer devices 350 that will be stored in the cabinet 100. Adapter brackets may be connected to the device support structures 102, 104, 202, 204 to selectively reduce the distance 604 to allow installation of computer devices 350 that require a smaller distance 604. This can be done by using adapter brackets similar to the narrowing adapter brackets 702 described above. Computer devices 350 that require a smaller depth distance 604 would then be attached to the adapter brackets, increasing the flexibility of the cabinet 100 and allowing the cabinet 100 to store many different types of computer devices 350 that require different depth distances 604.

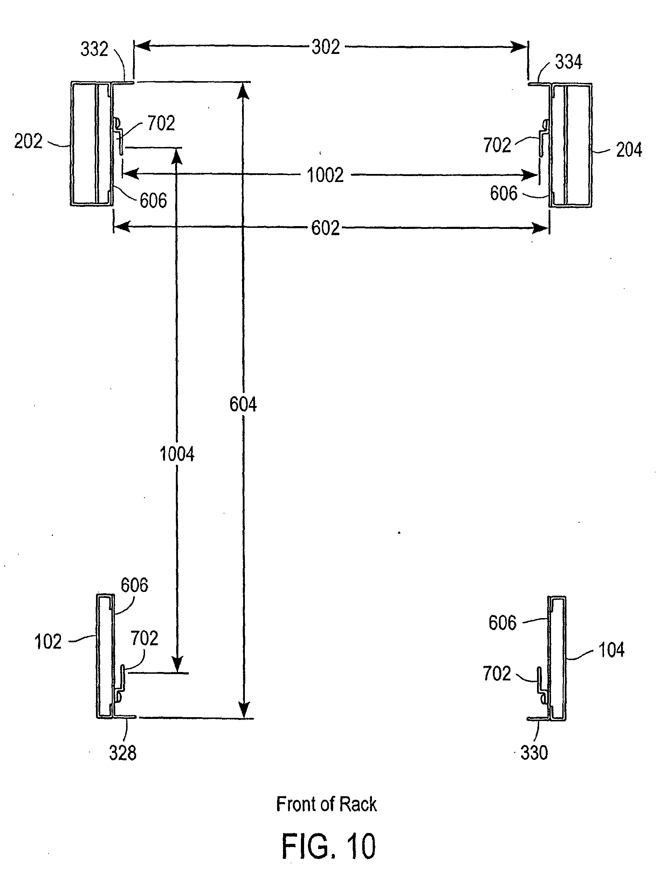

FIG 10 is a top view that illustrates four device support structures 102, 104, 202, 204 with the narrowing adapter brackets 702 installed. As seen in FIG 10, the depth distance 604 between the front rails 328, 330 and the rear rails 332, 334 remains the same as shown in FIG 6: approximately 29.13 inches. The front left and right rails 328, 330 and rear left and right rails 332, 334 are separated by a distance 302 of approximately 17.81 inches. The width 602 between the left and right rear device support structures 202, 204 and between the left and right front device support structures 102, 104 is approximately 19.76 inches. However, because the narrowing adapter brackets 702 have been installed, the effective width 1002 between the left and right rear device support structures 202, 204 and between the left and right front device support structures 102, 104 is narrower, approximately 18.80 inches. This allows installation of computer devices 350 that require a narrower effective width 1002 than the larger width 602.

In the embodiment illustrated in FIG 10, the narrowing adapter brackets 702 also provide a modified depth distance 1004. The computer device 350 for which the narrowing adapter brackets 702 are installed may require this modified depth distance 1004. In FIG 10, this modified depth distance is approximately 24 inches. Other computer devices 350 may require narrowing adapter brackets 702 that provide different modified depth distances 1004 that can be accommodated using appropriate narrowing adapter brackets 702.

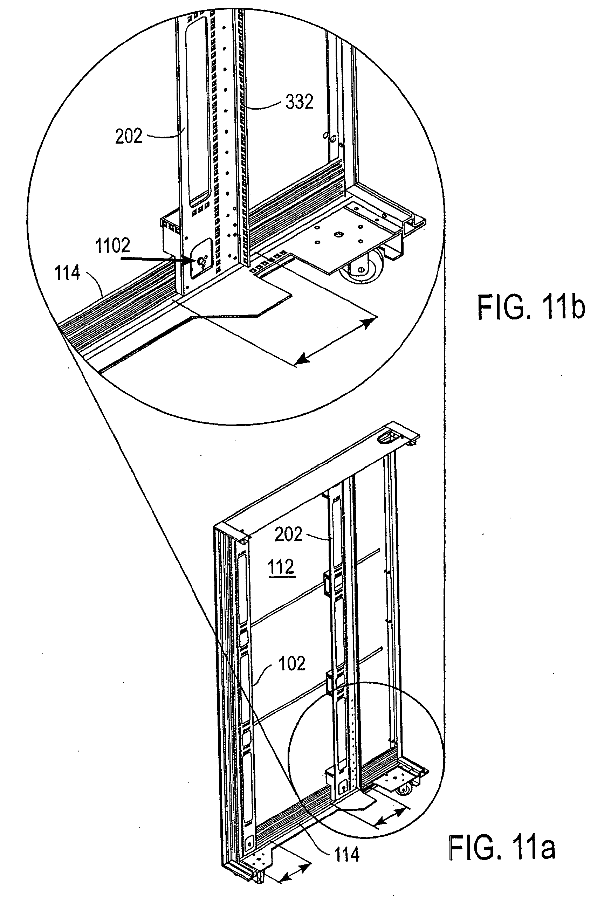

FIG 11a is a perspective view illustrating how the device support structures 102, 104, 202, 204 are positioned within the cabinet 100 along the tracks 114. FIG 11b is a close up perspective view showing more detail of the track 114 and how the device support structures 102, 104, 202, 204 are set in position along the track 114. While FIGs 11a-11b only show some of the device support structures 102, 104, 202, 204, the rest of the device support structures 102, 104, 202, 204 may be similarly positioned within the cabinet 100 along the tracks 114.

The device support structures 102, 104, 202, 204 can be positioned at any point along the tracks 114. As shown in FIG 11a, both the front and the rear device support structures 102, 202 may be independently moved forward or back along the tracks 114 and fixed in the desired position. In an alternative embodiment, the distance between the front and rear device support structures 102, 202 is fixed, but the device support structures 102, 202 may be moved as a unit forward or back along the tracks 114 to a desired position.

As seen in the embodiment illustrated in FIG 11b, a positioning screw 1102 is tightened to set the device support structure 202 in a desired position and prevent it from moving, or loosened to free the device support structure 202 and allow it to be repositioned. The positioning screw 1102 is threaded into a nut (not shown) that is located within the track 114. As the positioning screw 1102 is tightened into the nut, the screw 1102 forces the device support structure 202, as well as the nut, against the track 114. Friction between the nut and the track and the device support structure 202 and the track then prevents the device support structure 202 from moving away from the set position.

To change the position of the device support structure 202, the screw 1102 is loosened, releasing the force holding the device support structure 202 against the track 114. After the screw 1102 is loosened, both the device support structure 202 and the nut are able to slide forward or back along the track 114 so that the device support structure 202 may be positioned at any location along the track 114. After the device support structure 202 has been placed in a desired position, the screw 1102 is then retightened, so that the device support structure 202 is again set in place. As discussed above with respect to FIG 6, a depth distance 604 such as 29.13 inches is chosen because it is compatible with the requirements of a wide range of computer devices 350 from several different vendors.

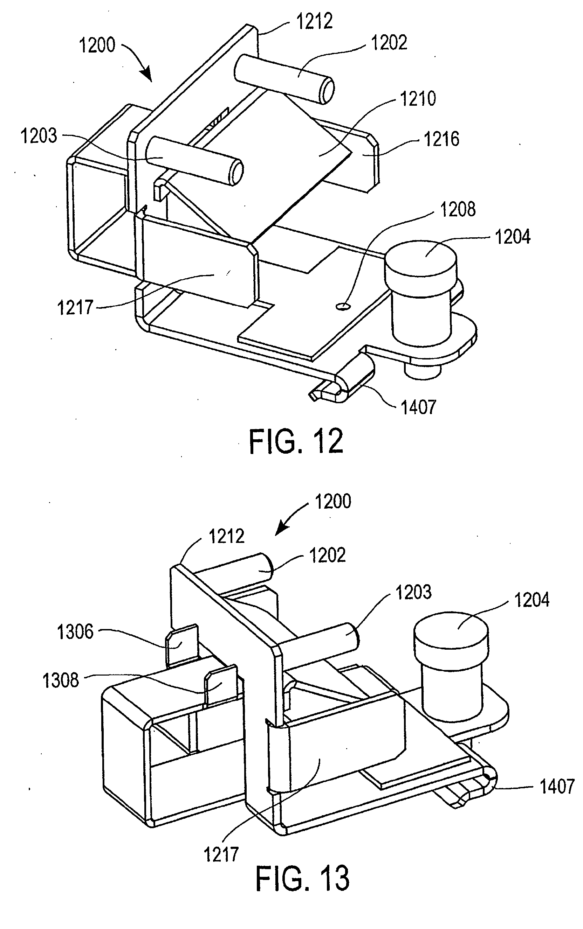

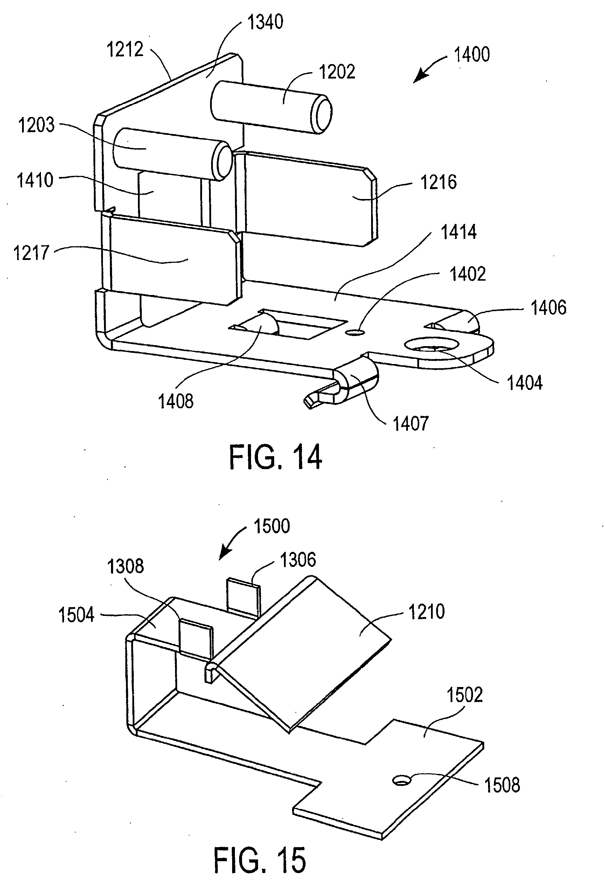

FIG 12 is a perspective view of the front, top, and left side of an assembled bracket apparatus according to one embodiment of the present invention. In this embodiment, the bracket apparatus 1200 is a two-part apparatus. FIG 12 illustrates the two parts of the bracket apparatus 1200 assembled to form the complete bracket apparatus 1200 and FIGs 14-15 illustrate the two parts as disassembled. The bracket apparatus 1200 comprises a frame 1212 that supports two guide pins, a right guide pin 1202 and a left guide pin 1203, onto which mounting holes of a computer component can be positioned. Though FIG 12 illustrates a bracket apparatus 1200 with a right guide pin 1202 and a left guide pin 1203, the bracket apparatus 1200 can alternatively have just one guide pin, or more than two guide pins to which mounting holes of a computer component can be attached. Also shown in FIG 12 is a release plunger 1204 for releasing the bracket apparatus 1200 from the enclosure. Two resting ledges, a right resting ledge 1216 and a left resting ledge 1217, are attached to either side of the frame 1212, and these resting ledges support a computer component during attachment to the bracket apparatus 1200. Also illustrated in FIG 12 is a release flap or release member 1210 that protrudes through a slot in the frame 1212. The release member 1210 assists in securing a computer component to the bracket apparatus 1200, and provides for the release of the component from the apparatus 1200.

FIG 13 is a perspective view of the rear, top, and left sides of the bracket apparatus 1200, according to one embodiment of the present invention. In FIG 13, two anti-rotation tabs, a right anti-rotation tab 1306 and a left anti-rotation tab 1308, are visible. These tabs assist in securing a computer component to the bracket apparatus 1200 such that the component is locked into place and cannot be easily rotated or accidentally detached from the apparatus 1200.

FIG 14 illustrates the main part 1400 of the disassembled two-part bracket apparatus 1200, according to one embodiment of the present invention. In one embodiment, a frame 1212 of the main part 1400 comprises an upper frame 1440 to which is attached the right guide pin 1202, the left guide pin 1203, the right resting ledge 1216, and left resting ledge 1217. The main part 1400 also comprises a frame base 1414, to which three fastener arms are attached, and the frame base 1414 further comprises a plunger insertion hole 1404. The plunger insertion hole 1404 holds the release plunger 1204, and the tip of the release plunger 1204 protrudes through the hole, as shown in FIG 12. In one embodiment, the three fastener arms comprise a right front fastener arm 1406, a left front fastener arm 1407, and one rear fastener arm 1408. These fastener arms attach to a support structure of an enclosure to secure the bracket apparatus 1200 into position. The invention is not limited to only three fastener arms, but instead there can be one or more fastener arms according to some embodiments of the invention. A lower spot weld alignment hole 1402 is illustrated in the frame base 1414. This hole permits alignment of the two parts of the bracket apparatus 1200 for the welding together of the two parts. A release slot 1410 in the upper frame 1440 allows for insertion of the release member 1210 that is shown in FIG 12.

Referring now to FIG 15, there is shown the insertion part 1500 of the disassembled two-part bracket apparatus 1200, according to one embodiment of the present invention. The frame of the insertion part 1500 comprises an insertion base 1502 and an insertion body 1504. An upper spot weld alignment hole 1508 in the insertion base 1502 provides for alignment of the two parts of the bracket apparatus 1200. The upper spot weld insertion hole 1508 can be aligned, as shown in FIG 12, with the lower spot weld insertion hole 1402 to permit alignment of the two parts of the bracket apparatus 1200 such that the two parts can be welded together if desired. The right anti-rotation tab 1306 and the left anti-rotation tab 1308 are attached to the insertion body 1404, as is the release member 1210.

Though the bracket apparatus 1200 shown in FIGs 12-15 is illustrated as being a two-part apparatus, the bracket apparatus 1200 can also be a one-part apparatus. In some embodiments, the main part 1400 and the insertion part 1500 are not detachable from each other.

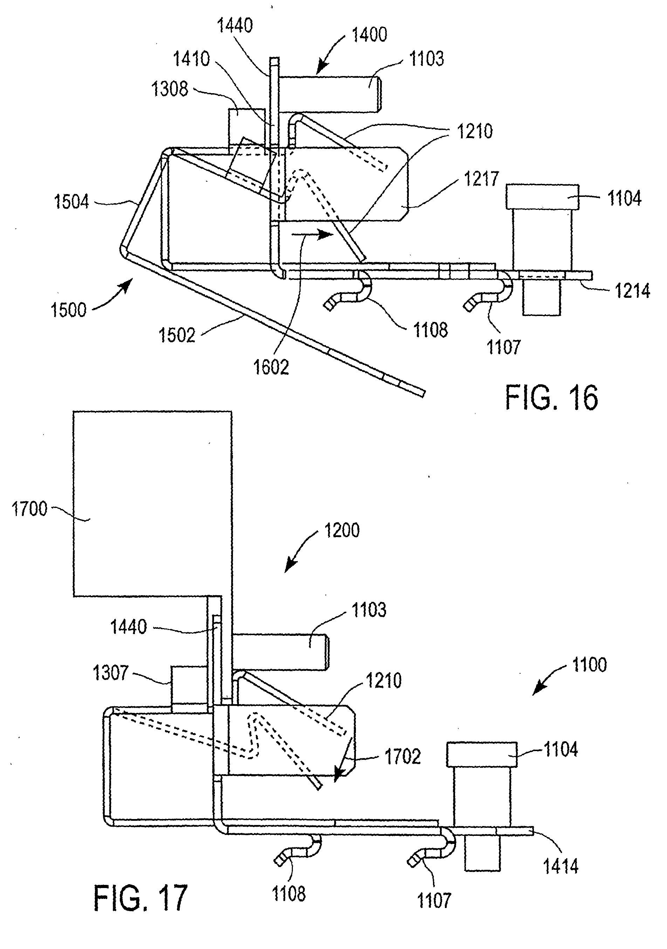

In assembling the two-part apparatus, the release member 1210 can be inserted into the release member slot 1410 in the direction 1602 shown in FIG 16, in one embodiment of the invention. Additionally, the insertion base 1502 can be inserted through the release member slot 1410, such that the insertion base 1502 rests on top of the frame base 1414. When assembled, the release member 1210 protrudes through the release member slot 1410 in the upper frame 1440. The right anti-rotation tab (not shown) and the left anti-rotation tab 1308 prevent the release member 1210 from being pulled more than a set distance through the release member slot 1410 by bracing the insertion part 1500 against the upper frame 1340.

Referring now to FIG 17, there is shown the bracket apparatus 1200 with a portion of a computer component 1700 attached to the apparatus 1200, according to one embodiment of the present invention. As shown in FIG 17, the computer component 1700 can be easily slid onto and off of the bracket apparatus 1200. To attach the computer component 1700 to the bracket apparatus 1200, the component 1700 is slid onto the right guide pin (not shown) and the left guide pin 1203, and the release member 1210 is pushed toward the frame base 1414. The component 1600 pushes the release member 1210 in the direction 1702 shown in the figure as the component 1700 is slid along the right guide pin (not shown) and the left guide pin 1103 toward the upper frame 1440. Once the computer component 1700 has moved a certain distance along the guide pins, the release member 1210 can return to its original position. When the computer component 1700 has been fully engaged by the bracket apparatus 1200, the component 1700 will be secured between the upper frame 1440 and the release member 1210, as shown in FIG 17.

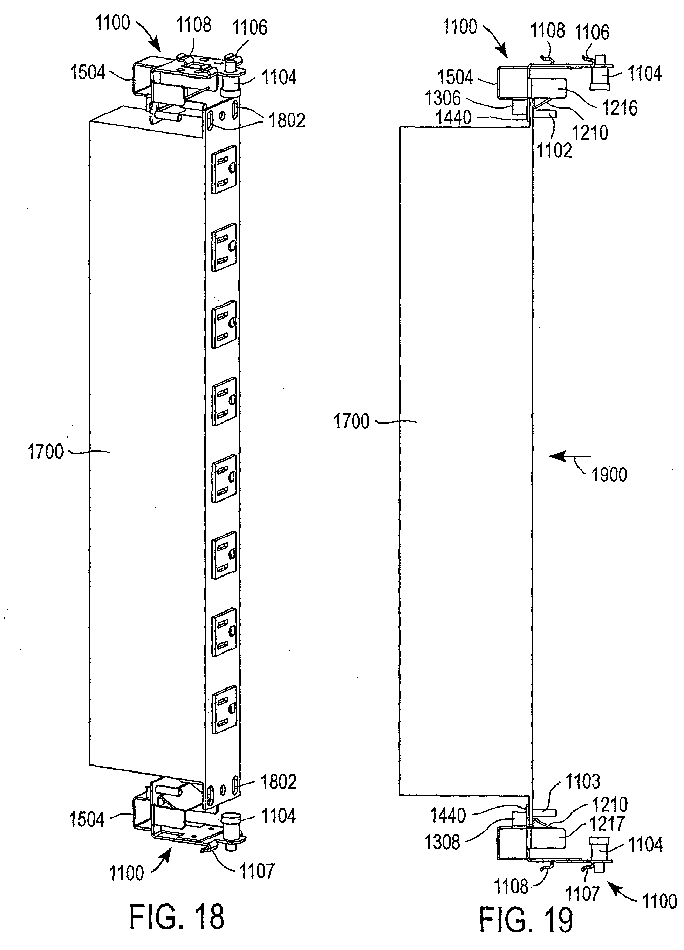

FIG 18 illustrates the attachment of two bracket apparatuses 1200 to either end of a computer component 1700, according to one embodiment of the present invention. In this illustration, the component 1700 is a power source, but the component 1700 can be different types of computer equipment as described above. As shown in FIG 18, the component 1700 can include mounting holes 1802 that allow the component 1700 to be attached to the bracket apparatus 1200. These mounting holes 1802 are shown as somewhat oval-shaped holes in the FIG 18, however these holes can take any shape. For example, the holes 1802 might be round or square, or the holes 1802 might include some type of adapter for adjusting the shape and/or size of the holes 1802. In addition, there can be any number of mounting holes 1802 that arranged in various configurations and located in various positions on the computer component 1700. In some embodiments, only one bracket apparatus 1200 may be needed to mount components, and in other embodiments, more than two bracket apparatuses will be used to mount components. FIG 18 illustrates two bracket apparatuses 1200 facing in reverse directions for mounting the computer component 1700. In other embodiments, the apparatuses 1200 might be configured in different manners, including facing in the same directions for mounting.

FIG 19 shows the computer component 1700 fully engaged with the bracket apparatus 1200, according to one embodiment of the present invention. In this embodiment, there is a bracket apparatus 1200 attached to the mounting holes 1802 in the top and the bottom of the component 1700, and the bracket apparatuses 1200 are attached in reverse directions. The computer component 1700 is slid in the direction 1900 shown to attach the component 1700 to the two bracket apparatuses 1200. The right guide pin 1202 and the left guide pin 1203 of the apparatuses 1200 are protruding through the mounting holes 1802, and the component 1700 is positioned between the upper frame 1440 and the release member 110. The right anti-rotation tab 1306 and left anti-rotation tab 1308 assist in holding the release member 1210 against the component 1700 such that the component 1700 cannot be easily rotated or knocked out of position.

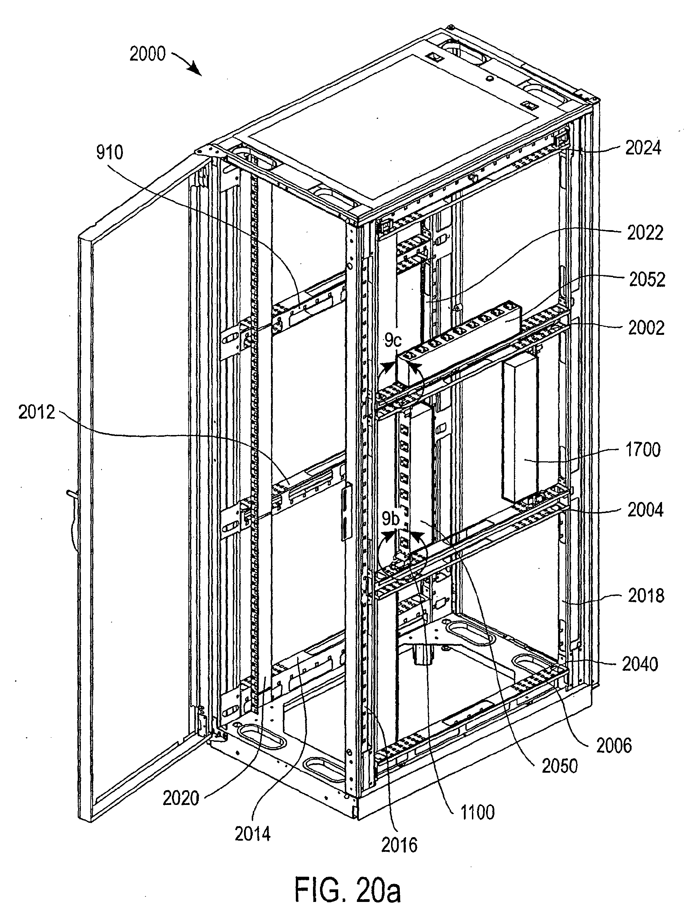

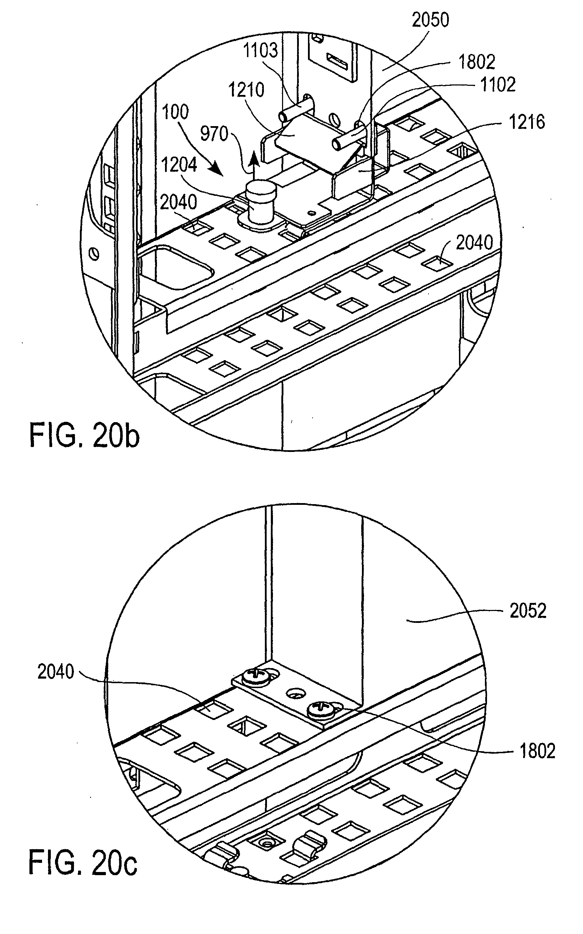

Referring now to FIG 20a, there is illustrated an enclosure 2000, according to one embodiment of the present invention. The enclosure 2000 comprises a number of vertical and horizontal support structures containing holes 2040 to which bracket apparatuses 1200 can be attached. FIG 20a shows four vertical supports, including a right front support member 2016, a right rear support member 2018, a left front support member 2020, and a left rear support member 2022. FIG 20a also shows a number of horizontal supports or frame tracks, including a right upper frame track 2024, a right upper middle frame track 2002, a right lower middle frame track 2004, a right lower frame track 2006, a left upper frame track (not shown), a left upper middle frame track 2010, a left lower middle frame track 2012, and a left lower frame track 2014. These support structures can vary in number and configuration in the enclosure 2000, and can also vary in width, length, and height.

FIG 20a also illustrates computer components and accessories attached at various locations along the frame tracks. The computer components 1700 can be attached along one frame track or can be attached in a manner that utilizes more than one frame track. For example, a component 1700 might be attached by a bracket apparatus 1200 at one end to the right upper frame track 2024 and by a bracket apparatus 1200 at the other end to a right upper middle frame track 2002. In the same manner, a component might be attached to both the right upper middle frame track 2002 and the right lower middle frame track 2004, or the right lower frame track 2006 and the right lower middle frame track 2004. In addition, a component might also be attached to the left side frame tracks in the same manner.

These various attachment configurations allow for space efficiency within the enclosure 2000. For example, as shown in FIG 20a, a first power source 2050 can be attached in a space efficient vertical configuration, in addition to the horizontal configuration of the second power source 2052. The second power source 2052 is attached using screws or some other attachment mechanism that requires tools. The second 2052 power source must be positioned such that it is not too close to either of the front or rear support members, since there must be space for maneuvering tools for attaching and removing the power source. Two horizontally positioned power sources will not fit on one frame track, thus wasting space in the enclosure. The horizontal position further uses up many of the mounting holes on a frame track by covering them up with the body of the power source 2052. In addition, even if a power source were attached with tools in a vertical configuration, space is still wasted because again the power sources cannot be positioned too close together or too close to the vertical support structures where they cannot be accessed by tools. Thus, the tool-less attachment of the bracket apparatus 1200 to the enclosure 2000 and the attachment of the components 2000 to the apparatus 1200 allows for a much easier attachment and removal so space in the cabinet is effectively used.

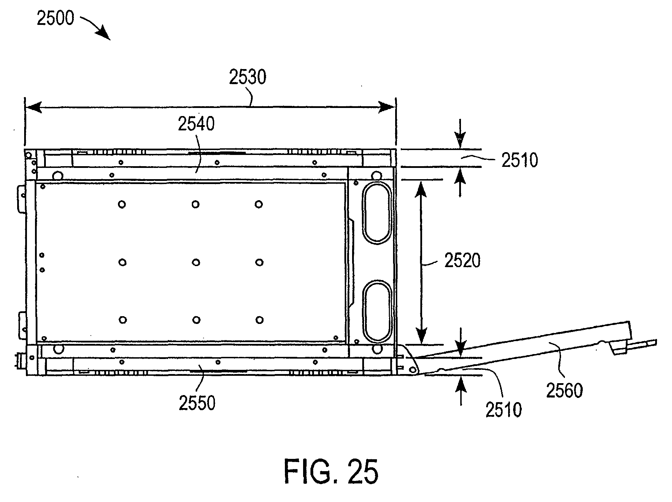

The frame track structures also provide for effective use of the zero unit space in the enclosure 2000. According to the EIA-310-D standard, the space within an enclosure 2000 is measured in rack units that are approximately 1.75 inches each, or are three support structure mounting holes 2040 in length. Each server mounted within an enclosure 2000 takes up a certain amount of rack unit space along the vertical support structures in the enclosure 2000. However, a certain amount of space is left open along the sides of the cabinet for ventilation, etc. and this open space is referred to as the zero unit space. The frame tracks run horizontally along this zero unit space and allow a place for computer components to be attached. The bracket apparatus 1200 works together with the frame tracks to permit easy attachment and easy removal of components 1700, so the zero units space can be fully utilized in an effective manner. Zero unit space is discussed in further detail below with respect to FIG. 25.

The bracket apparatus 1200 can also be used to attach components to the vertical support structures or support members. For example, the bracket apparatuses 1200 might be used to attach a server to the right front support member 2016, the right rear support member 2018, the left front support member 2020, and the left rear support member 2022.

FIG 20b illustrates a close-up view of the first power source 2050 attached to a frame track using a bracket apparatus 1200 in accordance with one embodiment of the present invention. The bracket apparatus 1200 allows the first power source 2050 to be easily snapped onto and off of the frame track. In contrast, FIG 20c illustrates a close-up view of the support mounting holes 2040 of a frame track with the second power source 2052 attached by screws. While the support mounting holes 2040 are illustrated as square holes, the holes 2040 can be any shape as described above in reference to mounting holes 1802.

Referring again to FIG 20b, the first power source 2050 is securely attached to the bracket apparatus 1200, which is in turn securely attached to the support mounting holes 2040 of the frame track. The right front fastener arm 1406 and the left front fastener 1407 along with the rear fastener 1408 are each attached to a different support mounting hole 2040. In addition, the tip of the release plunger 1204 is attached to a mounting hole. The bracket apparatus 1200 can be moved against the frame track to slide the fasteners, including the release plunger 1204, into the support mounting holes 2040 and snap the fasteners and the plunger into position. Once the bracket apparatus 1200 is secured to the frame track, the first power source 2050 can be easily snapped onto and off of the apparatus 1200. The bracket apparatus 1200 can be detached from the frame track by pulling the release plunger 1204 in a direction 2070 away from the frame track, such that the tip of the release plunger 1204 is removed from the support mounting hole 2040. The bracket apparatus 1200 can then be slid off of the frame track by moving the apparatus 1200 against the frame track in a direction opposite that used to attach the apparatus 1200. This will unsnap the fastener arms from the support mounting holes 2040 to free the apparatus 1200.

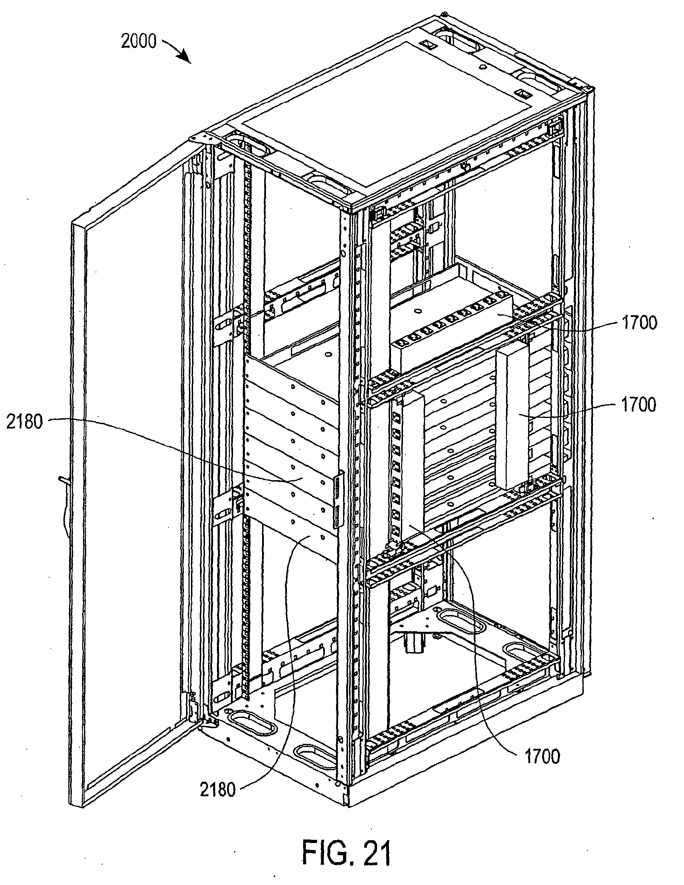

FIG 21 illustrates the cabinet 2000 of FIG. 20a with servers 2180 attached inside. This embodiment is an example of the difficulty in accessing the computer accessories (or components) 1700 with tools. The servers 2180 take up a large amount of space in the cabinet 2000, making it difficult to maneuver near the accessories 1700 with tools for attachment, removal, or adjustments of accessories 1700.

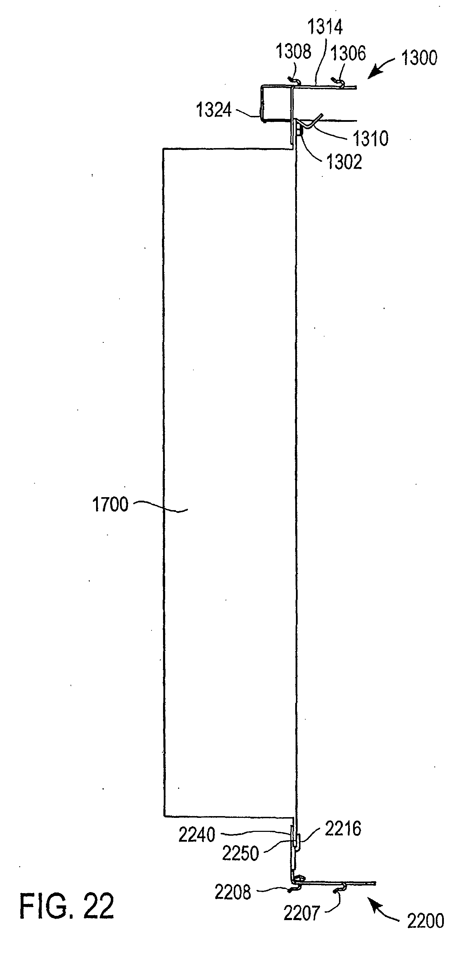

FIG 22 illustrates both bracket apparatus 2200 and bracket apparatus 1300 attached to a computer component 1700. FIG 22 shows the manner in which the edge of the component rests inside the resting pocket 2250, where the guide tabs can engage the mounting holes (not shown) to secure the component 1700 in place. Further, FIG 22 illustrates how the component 1700 is secured by the apparatus 1300 such that the mounting holes engage the right guide pin 1302 and the left guide pin (not shown). The release member 1310 also secures the component 1700 in position. Pressing the release member 1310 toward the frame base 1314 allows the component 1700 to be slid from the pins and removed from the bracket apparatus 1300. In one embodiment, a component 1700 is attached to apparatuses 2200 and 1300 by sliding an edge of the component 1700 into the resting pocket 2250 of apparatus 2200 to lock the edge of the component 1700 into position, and the other edge of the component 1700 is pressed against apparatus 1300 to lock it into place. The component 1700 is released from the apparatuses by pressing release member 1310 toward frame base 1314 so that component 1700 can be slid off of the apparatus 1300, and the guide tabs (not shown) are pressed toward upper frame 2240 to disengage the mounting holes of the component 1700 from the tabs and slide the component out of the resting pocket 2250.

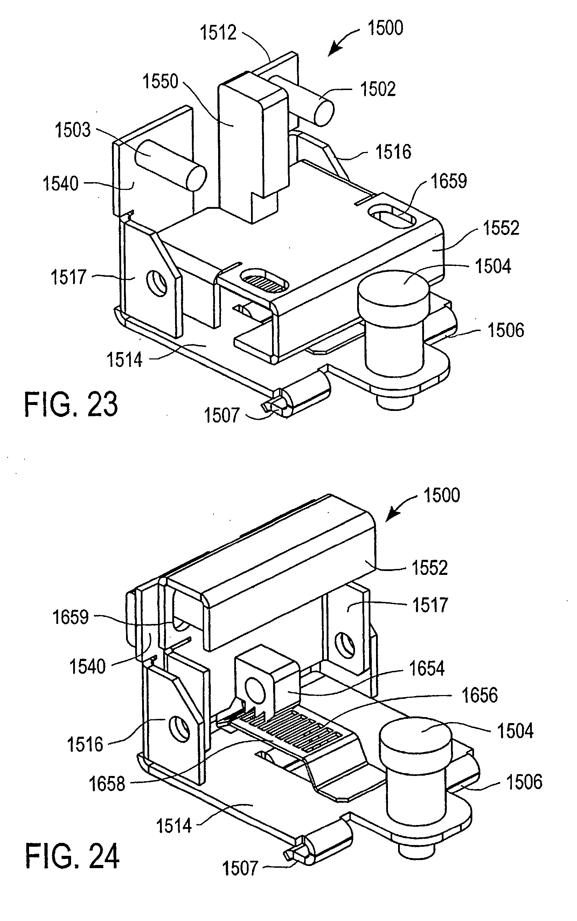

Referring now to FIG 23, there is shown a multiple piece bracket apparatus 1500 with a pivotable bar 1552 for securing a component into position. The bracket apparatus 1500 comprises a frame 1512, including an upper frame 1540 and a frame base 1514. The upper frame 1540 supports two guide pins, a right guide pin 1502 and a left guide pin 1503, to which mounting holes of a computer component can be attached. Also shown in FIG 23 is a release plunger 1504 for releasing the bracket apparatus 1500 from the enclosure, as described above in relation to apparatus 1200. Two resting ledges, a right resting ledge 1516 and a left resting ledge 1517, are attached to either side of the frame 1512, and these resting ledges support a computer component during attachment to the bracket apparatus 1500. Bracket apparatus 1500 further comprises a right front fastener 1506, a left front fastener 1507, and rear fastener (not shown) for attaching the apparatus 1500 to an enclosure, as described above.

In one embodiment, apparatus 1500 comprises a pivotable bar 1552 that secures a component onto the apparatus 1500. FIG 23 illustrates the apparatus 1500 in an open position, where the pivotable bar 1552 is pivoted toward the frame base 1514. A pawl 1550, which is coupled to the pivotable bar 1552 is in an upright position.

FIG 24 illustrates the apparatus 1500 in a closed position, with the pivotable bar 1552 pivoted toward the upper frame 1540 and the pin engagement holes 1659 of the pivotable bar 1552 engage the guide pins, according to one embodiment of the present invention. A notched member 1654 is coupled to the pivotable bar 1552. Additionally, a release member 1658 is coupled to the frame base 1514. The release member 1658 further has a threaded portion 1656. The notched member 1654 engages the threaded portion 1656 to lock the pivotable bar 1552 into a closed position. Pressing the release member 1658 toward the frame base 1514 causes the notched member 1654 to be disengaged from the threaded portion 1656 such that the pivotable bar 1552 is free to pivot.

FIG. 25 is a bottom view that illustrates dimensions of zero rack unit space according to one embodiment of the present invention. This perspective of the cabinet 250 shows horizontal members 2540, 2550, front panel 2560, a width of zero unit space 2510 and a depth of zero unit space 2530. The width of zero unit space 2510 is approximately, for example, a width of the vertical members 2500a-d, a width required by equipment vendors for cooling space (e.g., 8 inches), a width of the enclosure 2500 minus a width 2520 of rack unit space, etc. The depth of zero unit space 2530 is approximately, for example, a distance between a front vertical member and a back vertical member (e.g., 110b to 110c) and back vertical members 110c-d, a depth of the enclosure 2500, etc. A height of zero unit space (not shown) is approximately, for example, a distance between horizontal members 160, a height of the enclosure, etc. In one embodiment, dimensions of zero unit space add no additional dimensions to the enclosure 2500.

In one embodiment, the distance between the inside edges of the left and right front vertical members 1 10a-b is approximately 17.81 inches so that devices conforming to the EIA-310-D standard will fit correctly when attaching them to the vertical members 1 10a-d. In other embodiments, the distances between the vertical members 110a-d can be different to comply with a different standard or with various non-standard computer devices.

In another embodiment, the depth distance of 29.13 inches is chosen because it is compatible with the requirements of the EIA-310-D standard as well as the requirements of a wide range of computer-related devices 140 from several different vendors. In one embodiment, this distance of 29.13 inches is chosen because it is the distance specified for use with one of the multiple computer-related devices 140 with which the enclosure 2500 is to be used and falls within an allowable range of distances specified by the rest of the multiple computer-related devices 140 with which the enclosure 2500 is to be used. In yet another embodiment, the accessories are mounted to the frame using tool-less adaptors.

## Claims

1. A computer device cabinet adapted to mount and store a plurality of computer devices with varying mount and store requirements, comprising:
a plurality of device support structures positioned to support a first computer device having a first depth and a first width;
a plurality of tracks, slidably connected to the plurality of device support structures, the plurality of tracks allowing positioning of the plurality of device support structures to approximately the first depth; and
a plurality of narrowing adaptors, connected to mounting holes within the plurality of device support structures, the plurality of narrowing adaptors providing support at approximately the first width.

2. The cabinet of claim 1, wherein the plurality of device support structures also support a second computer device having a second depth less than the first depth, and wherein the plurality of narrowing adaptors provide support at approximately the second depth.

3. The cabinet of claim 1, wherein the plurality of device support structures also support a second computer device having a second depth less than the first depth and approximately the first width, and wherein the plurality of narrowing adaptors provide support at approximately the second depth.

4. The cabinet of claim 1, wherein the first computer device is adapted to connect to mounting holes having a different size or shape than the mounting holes within the plurality of device support structures.

5. The cabinet of claim 1, wherein the plurality of support structures comprise front and rear support structures are separated by a depth, and left and right support structures are separated by a width, and the mounting holes have a spacing, wherein the depth, the width, and the spacing each comply with the EIA-310-D (Electronic Industries Association) standard.

6. The cabinet of claim 1, wherein the plurality of computer devices comprise at least two computer devices having different vendors.

7. A method of mounting and storing a plurality of computer devices with varying mount and store requirements, the method comprising the steps of:
providing support for a first computer device having a first depth and a first width;
repositioning to support the first computer device at approximately the first depth; and
narrowing to mount the first computer device at approximately the first width.

8. The method of claim 7, wherein the step of providing support for the first computer device further comprises providing support for a second computer device having a second depth less than the first depth, and approximately the first width, and wherein the step of narrowing to support the first computer device further comprises narrowing supports to the second computer device at approximately the second depth.

9. The method of claim 7, wherein the step of providing support for the first computer device comprises providing support for the first computer device at the first depth and the first width, and wherein the step of narrowing to mount the first computer device comprises narrowing to mount the first computer device at according to a spacing, wherein the first depth, the first width, and the spacing each comply with the EIA-310-D (Electronic Industries Association) standard.

10. An apparatus for mounting computer components in an enclosure, the apparatus comprising:
at least one fastener coupled to a frame, the fastener being adapted for connecting to an enclosure without requiring the use of a tool;
at least one guide pin coupled to the frame, the pin being adapted to receive a computer component for attachment of the component to the apparatus; and
a release member coupled to a frame, the release member being resilient and being adapted for attaching a computer component to the connection apparatus by engaging the computer component, wherein manipulation of the release member releases the computer component from the connection apparatus.

11. The apparatus of claim 10, wherein the apparatus does not require the use of tools for mounting computer components in an enclosure or releasing computer components from an enclosure.

12. The apparatus of claim 10, wherein the apparatus is adapted for attachment to at least one support structure in an enclosure by securing the apparatus to at least one hole in the support structure.

13. The apparatus of claim 10, wherein pressing the release member toward the fastener releases the computer component from the connection apparatus.

14. The apparatus of claim 10, wherein at least one fastener further comprises two front fastener arms and one rear fastener arm for attaching to holes in a support structure of an enclosure.

15. The apparatus of claim 10, wherein the apparatus comprises two detachable parts, a first part comprising a first frame coupled to at least one fastener and at least one guide pin, and a second part comprising a second frame coupled to the release member.

16. The apparatus of claim 10, further comprising a resting pocket for supporting the edge of the computer component on the apparatus.

17. The apparatus of claim 10, further comprising a pivotable bar that engages the computer component as mounting holes on the component slide onto at least one guide pin, wherein the pivotable bar pivots to secure the component against a frame of the mounting apparatus and a notched edge of the bar engages a threaded portion on the release member to lock the bar into position.

18. A method for attaching computer components in an enclosure by attaching a mounting apparatus to the enclosure and attaching a computer component to the mounting apparatus that is adapted to receive computer components, the method comprising the steps of:
connecting a mounting apparatus to a support member of an enclosure by attaching at least one fastener of the mounting apparatus to the enclosure without the use of a tool;
engaging a computer component with a least one guide pin of the mounting apparatus that is adapted to receive computer components; and
securing the computer component to the mounting apparatus by engaging the computer component with a release member of the mounting apparatus without the use of the tool.

19. The method of claim 18, further comprising the steps of:
unsecuring the computer component from a mounting apparatus that is adapted to receive computer components by manipulating a release member of the mounting apparatus to disengage the computer component without the use of a tool;
disengaging the computer component from at least one guide pin of the mounting apparatus; and
disconnecting a mounting apparatus from a support member of an enclosure by detaching at least one fastener of the mounting apparatus from the enclosure without the use of the tool.

20. An computer device cabinet adapted to store accessories in zero rack unit space, the enclosure comprising:
a frame having support members to support one or more computer-related devices in rack unit space; and
one or more frame tracks, coupled to the frame, the one or more frame tracks adapted to attach an accessory for the computer-related devices to openings located in zero rack unit space.

21. The cabinet of claim 20, wherein zero rack unit space does not increase dimensions of the enclosure.

22. The cabinet of claim 20, wherein the frame and the one or more frame tracks conform to the EIA-310-D (Electronics Industries Association-310-D) standard.

23. The cabinet of claim 20, wherein the accessory comprises one from the group consisting of: a power source, a cooling device, and a wire guide.
